(19) Europäisches Patentamt
European Patent Office
Office européen des brevets

(11) **EP 4 097 431 B1**

(12) **EUROPÄISCHE PATENTSCHRIFT**

(45) Veröffentlichungstag und Bekanntmachung des Hinweises auf die Patenterteilung:
**11.09.2024  Patentblatt 2024/37**

(21) Anmeldenummer: **21702202.9**

(22) Anmeldetag: **25.01.2021**

(51) Internationale Patentklassifikation (IPC):
**G01J 1/42** (2006.01)     **G01J 5/12** (2006.01)

(52) Gemeinsame Patentklassifikation (CPC):
**G01J 5/12; G01J 1/4257**

(86) Internationale Anmeldenummer:
**PCT/EP2021/051594**

(87) Internationale Veröffentlichungsnummer:
**WO 2021/151825 (05.08.2021 Gazette 2021/31)**

(54) **HOCHLEISTUNGSSTRAHLUNGSSENSOR**

HIGH-PERFORMANCE RADIATION SENSOR

CAPTEUR DE RAYONNEMENTS À HAUTES PERFORMANCES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.01.2020   CH 922020**

(43) Veröffentlichungstag der Anmeldung:
**07.12.2022   Patentblatt 2022/49**

(73) Patentinhaber: **greenTEG AG**
**8153 Ruemlang (CH)**

(72) Erfinder:
• ZAHNER, Michele
  8153 Rümlang (CH)
• SCHWYTER, Etienne
  8153 Rümlang (CH)
• EB, Philipp
  8153 Rümlang (CH)
• LIPS, Tobias
  8153 Rümlang (CH)
• DURRER, Lukas
  8153 Rümlang (CH)

(74) Vertreter: **Prins Intellectual Property AG**
**Postfach 1739**
**8027 Zürich (CH)**

(56) Entgegenhaltungen:
DE-A1- 10 339 952     DE-A1- 19 804 487
US-A- 4 641 134

• S DRÖSCHER ET AL: "Reinventing Thermal Laser Power Measurements", LASERS IN MANUFACTURING CONFERENCE, 1 January 2015 (2015-01-01), XP055715818, Retrieved from the Internet <URL:https://www.wlt.de/lim/Proceedings2015/Stick/PDF/Contribution333_final.pdf> [retrieved on 20200717]
• SUSANNE DRÖSCHER ET AL: "Sensors for Terahertz Spectroscopy and Quantum Cascade Lasers Novel thermopile sensors detect laser power in the low  W-range", 1 January 2015 (2015-01-01), XP055715820, Retrieved from the Internet <URL:https://onlinelibrary.wiley.com/doi/pdfdirect/10.1002/opph.201500001> [retrieved on 20200717]

## Beschreibung

### Technisches Gebiet

Die vorliegende Erfindung beschreibt eine Verwendung eines Peltierelements als Hochleistungsstrahlungssensor für elektromagnetische Strahlung mit Wellenlängen bis zu 100μm mit Strahlungsleistungen grösser 100 Watt und einen Hochleistungsstrahlungssensor für hochenergetische Laserstrahlung mit Strahlungsleistungen grösser 100 Watt.

### Stand der Technik

Es gibt einige Anwendungsgebiete, in welchen das Auftreffen einer Strahlungsleistung von elektromagnetischer Strahlung gemessen werden soll. In all diesen Bereichen, lassen sich Hochleistungsstrahlungssensoren gemäss der folgenden Erfindung verwenden. Bevorzugt werden hier Hochleistungsstrahlungssensoren, die zur Messung hochenergetischer Laserstrahlung mit Strahlungsleistungen grösser 100 Watt eingesetzt werden. Dabei weist die besonders interessierende elektromagnetische Strahlung Wellenlängen bis zu 100μm auf. Die Art der Strahlung, ionisierend oder nicht, spielt hier für die Definition der Hochleistung keine Rolle. Mit Hochleistungsstrahlung ist also eine elektromagnetische Strahlung gemeint, die eine Strahlungsleistung von 100 Watt und mehr aufweist.

In diversen Anwendungsgebieten von elektromagnetischer Strahlung, sollte die Strahlungsleistung der Strahlung gemessen werden, um die Messergebnisse weiter zu nutzen. Beispielsweise werden Laserstrahlen in der Materialbearbeitung, in Laserstrahlschneidmaschinen oder in der Medizintechnik eingesetzt, wobei austretende Laserstrahlung auch detektiert werden sollte. Laserstrahlung in einem Wellenlängenbereich von ca. 1 μm, durch Nd:YAG-Laser, Faserlaser oder Scheibenlaser erreichbar ist hier speziell interessant.

Vor allem bei der Verwendung hochenergetischer Laserstrahlung mit Strahlungsleistungen grössergleich 100 Watt, können durch geeignete Messungen und Kontrollen der Laserstrahlung, Schäden oder Prozesfehler vermieden werden. Leider stossen bekannte Laserstrahlungssensoren bei solch hohen Laserleistungen an ihre Grenzen.

Die grosse Herausforderung bei Laserstrahlleistungsmesser für Leistungen grösser als 100 W ist die starke Erwärmung des Sensormoduls, insbesondere an der Oberfläche, welche die Absorber Schicht oder den Sensor zerstören können. Deshalb ist es wichtig, die Hitze gut ableiten zu können und trotzdem noch genügend gute Sensitivität zu haben.

Aus der DE19804487 ist beispielsweise ein Laserstrahlungssensor bekannt, welcher mehrere Lagen von Thermoelementen bzw. elektrisch leitenden Schichten verschiedener Materialien mit verschiedenen absoluten Thermokräften aufweist, wobei die Normale zu den verschiedenen Materialschichten in einem Kippwinkel zur Oberflächennormale geneigt sein soll. Die verschiedenen Schichten folgend alternierend aufeinander. Durch auftreffende Laserstrahlung wird ein thermoelektrisches Feld erzeugt, welches durch Messung elektrischer Spannungen bestimmt werden kann, sodass ein Strahlungsdetektor erzeugt werden konnte. Der Seebeck-Effekt in den verschiedenen Materialien wird dafür ausgenutzt.

Nachteilig an dieser Art des Strahlungsdetektors ist die spezielle verkippte Kupfer-Konstantan-Multilagenstruktur, aus Mikrometerdicken Lagen und deren komplizierte Herstellung. Dabei muss der Kippwinkel in einem engen Bereich zwischen 20° und 40° liegen. Es ist fraglich, ob der Strahlungsdetektor gemäss DE19804487, bei Einstrahlung von Laserstrahlungsleistungen grösser 100 W einsetzbar ist, was aus DE19804487 nicht hervorgeht. Auch, ob ein solcher Strahlungsdetektor ausreichend robust ist, also bei hochenergetischer Strahlung nicht schmilzt oder angegriffen wird, kann DE19804487 nicht entnommen werden.

In der US4641134 wird ein IR-Strahlungssensor mit einem konventionell erhältlichen Peltierelement offenbart, welcher nur zur Messung niederenergetischer IR-Strahlung, also von Wärmestrahlung, wie sie von Menschen oder Tieren abgestrahlt wird, verwendet werden soll. Ein solches Peltierelement muss hochsensitiv sein und auf geringe Strahlungsintensitätsschwankungen im Bereich typischer Strahlungsleistungen von Menschen und Tieren kalibriert sein. Schon Strahlungsleistungen im zweistelligen Wattbereich sind für derartige Peltierelemente zu viel. Im Bereich um die 10 μm müssen diese Peltierelemente besonders empfindlich sein, damit sie bestimmungsgemäss detektieren. Zur Messung höherer Strahlungsleistungen würde ein Peltierelement aus der US4641134 nicht eingesetzt werden.

Aus DE10339952 geht ein Peltierelement als Mikropeltierelement hervor, welches einen speziellen Aufbau und eine spezielle Materialauswahl aufweist. Dabei ist ausschliesslich von Halbleitermaterialien die Rede, welche bekannte Wärmeleitfähigkeiten und bekannte Seebeck-Koeffizienten aufweisen. Derartige Mikropeltierelemente sind aber für die erfindungsgemäss geplante Verwendung beim Einsatz hochenergetischer Laserstrahlung mit Strahlungsleistungen grösser 100 Watt nicht einsetzbar. Davon wird auch nichts in der DE10339952 erwähnt.

### Darstellung der Erfindung

Die vorliegende Erfindung hat sich zur Aufgabe gestellt, einen Hochleistungsstrahlungssensor zu schaffen, der auch schadlos Laserstrahlung mit einer Strahlungsleistung grösser 100 Watt detektieren kann und einfach herstellbar ist.

Es hat sich gezeigt, dass die Verwendung spezieller Peltierelemente diese Aufgabe löst. Dabei ist vor allem die Materialwahl der Thermosäulen von Peltierelementen angepasst worden.

Aufgrund der aus dem Stand der Technik bekannten halbleiterbasierten Peltierelemente mit spröden Thermosäulen, beispielhaft wird auf die US3226804 verwiesen, kam bislang niemand auf die Idee, spezielle Peltierelemente als Hochleistungsstrahlungssensor zu verwenden bzw. entsprechend angepasst weiter zu entwickeln. Peltier Elemente sind weit verbreitet und können kostengünstig hergestellt werden.

Es sollte ein Hochleistungsstrahlungssensor geschaffen werden, welcher eine möglichst hohe Sensitivität zeigt, eine möglichst hohe Homogenität der Temperaturverteilung aufweist, um "hot spots" zu vermeiden und eine möglichst hohe Homogenität der Sensitivität aufweist. Wichtig dabei ist, dass man den thermischen Widerstand des Hochleistungsstrahlungssensor durch geeignete Materialkombination oder Miniaturisierung des Hochleistungsstrahlungssensors so weit erniedrigt, dass die an der Oberfläche gebildete Wärmeleistung rasch abgeführt werden kann und dadurch die Temperatur des Hochleistungsstrahlungssensors unter der Schmelztemperatur der Lotverbindungen gehalten werden kann. Trotzdem sollte der Seebeck-Effekt der Materialien genügend gut ausgeprägt sein, um eine ausreichende Signalauflösung zu erreichen. Dabei sollte eine einfache Herstellung durchführbar sein, die zu einer hohen mechanischen und thermischen Robustheit und thermischer Wechselfestigkeit bzw. Cyklierbarkeit führt.

Variationen von Merkmalskombinationen bzw. geringfügige Anpassungen der Erfindung sind in der Detailbeschreibung zu finden, in der Figur abgebildet und in die abhängigen Patentansprüche aufgenommen worden.

## Kurze Beschreibung der Zeichnungen

Der Erfindungsgegenstand wird nachstehend detailliert im Zusammenhang mit der anliegenden Zeichnung beschrieben. Notwendige Merkmale, Einzelheiten und Vorzüge der Erfindung ergeben sich aus der zugehörigen nachfolgenden Beschreibung. Notwendige Minimalmerkmale, Zusatzmerkmale und optionale Merkmale sind im Detail erläutert.

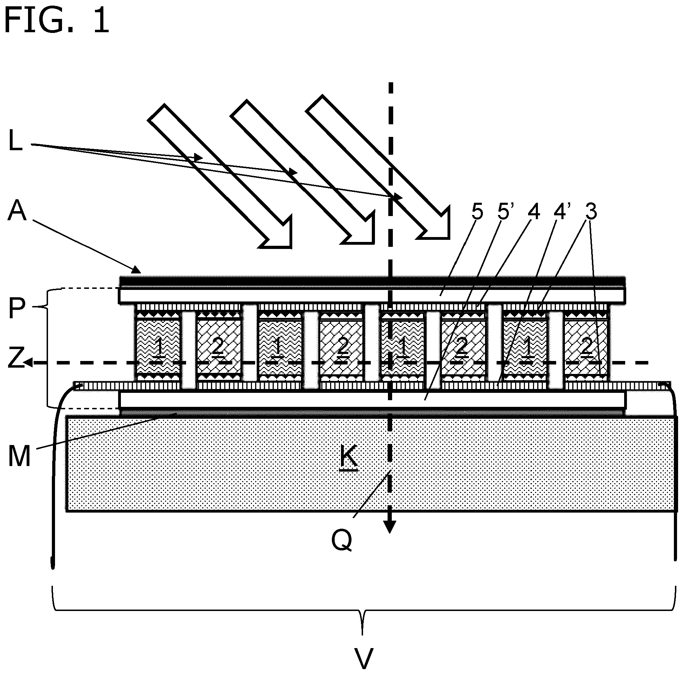

Figur 1    zeigt eine Schematische Schnittansicht durch ein spezielles Peltierelement, welches als Hochleistungsstrahlungssensor verwendet wird, beispielhaft für die Analyse von hochenergetischer Laserstrahlung.

## Beschreibung

Peltierelemente P umfassen immer mindestens zwei Arten von Thermosäulen 1, 2, welche alternierend in Reihen angeordnet sind. Im Gegenteil zu aus dem Stand der Technik bekannten Peltierelementen P, sind hier andere Anforderungen an die Thermosäulen 1, 2 gestellt, welche unten ausführlich erläutert werden.

Bevorzugt sind die Thermosäulen 1, 2 quaderförmig mit quadratischem Querschnitt geformt. Zwischen den Thermosäulen 1, 2 sind Abstände vorgesehen, diese können mit Luft oder einer Materiallage aus einem Festkörper gefüllt sein, sodass sich zwischen benachbarten Thermosäulen 1, 2 kein elektrischer Kontakt ausbilden kann. Die Thermosäulen 1, 2 sind an ihren vertikalen Enden, in Querrichtung Q des Peltierelementes P beabstandet, mit Säulenlotschichtlagen 3 versehen, an welchen direkt benachbarte unterschiedliche Thermosäulen 1, 2 über Säulenbrücken 4, 4' stoffschlüssig verbunden angelötet befestigt sind.

Es sind obere Säulenbrücken 4, der Oberseite des Peltierelementes P, der späteren Laserstrahlung L zugewandt und untere Säulenbrücken 4', der Unterseite des Peltierelementes P, einem optionalen Kühlkörper K zugewandt, vorgesehen. Die oberen Säulenbrücken 4 und die unteren Säulenbrücken 4' sind um die Thermosäulen 1, 2 in Querrichtung Q beabstandet voneinander angeordnet.

Über eine strahlungsseitige Isolatorlage 5 und eine kühlkörperseitige Isolatorlage 5' ist ein Sandwichaufbau des gesamten Peltierelementes P erreicht. Die Isolatorlagen 5, 5' sollen hitzebeständig sein, thermisch leitend aber elektrisch isolierend. Die Isolatorlagen 5, 5' sind an den gegenüberliegenden Säulenbrücken 4 verbunden. In der Praxis umfassen die Isolatorlagen 5, 5' Aluminiumoxid, Aluminiumnitrid, Berylliumoxid, «Metallkern Leiterplatten» ("Insulated Metallic substrats") oder anodisierte Metalle.

Die stoffschlüssige Verbindung der Säulenbrücken 4, 4' und Isolatorlagen 5, 5' erfolgt üblicherweise durch Weich- oder Hartlote. Die Säulenlotschichtlage 3 muss thermisch leitfähig sein und ein entsprechendes Weich- oder Hartlot auf Basis von Zinn, Silber, Messing und/oder Kupfer umfassen.

Damit die Temperatur der bestrahlten Oberfläche möglichst klein bleibt und die Säulenbrücken 4 keinen Schaden nehmen, muss der thermische Gesamtwiderstand des gesamten Peltierelementes P parallel zur Querrichtung Q, in der thermischen Flussrichtung, von der Oberseite auf die Unterseite des gesamten Peltierelementes P möglichst klein gehalten werden.

Für eine Strahlungsleistung von 100W sollte der thermische Gesamtwiderstand des gesamten Peltierelementes P 2 K/W nicht überschreiten, während bei einer Strahlungsleistung von 1000 W, der thermische Gesamtwiderstand des gesamten Peltierelementes P 0.2 K/W bzw. 0.1 K/W nicht übersteigt.

Die Messung von thermischen Widerständen einzelner Thermosäulen 1, 2 und des thermischen Gesamtwiderstands des gesamten Peltierelementes P, ist mit bekannten Mitteln durchführbar.

Die maximale Temperaturdifferenz dTmax zwischen Sensoroberfläche und -Rückseite zum Kühlkörper K, beispielsweise mit Kühlwasser, soll nicht mehr als 200K, vorzugsweise nicht mehr als 100K betragen, so dass auch bei Verwendung von herkömmlichem SAC Zinnlot mit einer Schmelztemperatur von 210°C, die Schmelztemperatr des Lotes an keiner Stelle des Peltierelementes P zu keinem Zeitpunkt erreicht wird.

Der maximale the mische Widerstand Rmax Bei einer gegebenen Strahlungsleistung S darf somit maximal Rmax = dTmax / S betragen.

Es hat sich gezeigt, dass die Materialien A, B der Thermosäulen 1, 2, halbleiterfrei, duktil und mit ähnlich hohen thermischen Leitfähigkeiten ausgeführt sein müssen.

Die hier verwendbaren Materialien A, B haben einen im Vergleich zu bekannten Halbleitermaterialien geringeren Seebeck-Effekt, welcher sich in den entsprechenden Seebeck-Koeffizienten niederschlägt. Dafür sind die thermischen Leitfähigkeiten der Materialien A, B hier deutlich höher, als die thermischen Leitfähigkeiten der sonst für die Thermosäulen von Peltierelementen aus dem Stand der Technik üblichen Halbleiter.

Das Peltierelement P weist hier eine thermisch aktive Lage aus den alternierend angeordneten ersten Thermosäulen 1 umfassend ein erstes Material A und zweite Thermosäulen 2 umfassend ein zweites Material B auf. Dabei soll das erste und zweite Material A, B jeweils einen Seebeck-Koeffizient, gemessen relativ zu Platin bei 273 K grösser 6 $\mu$V/K bzw. kleinergleich 15 $\mu$V/K aufweisen.

Besonders bevorzugt ist das erste Material A oder zweite Material Beines der folgenden Metalle bzw. Metalllegierungen: Kupfer, Kohlenstoffstahl, Eisen, Chromei, Konstantan, Alumel oder Nickel bzw. Legierungen daraus.

Diese Materialien A, B kommen in sämtlichen Kombinationen in Frage, weisen aber je nach Mischung unterschiedlich gute technische Wirkungen eines resultierenden Hochleistungsstrahlungssensor auf.

*Tabelle 1: Beispiele der Materialien A, B*

| | Seebeck vs Pt | Wärmeleitfähigkeit |
|---|---|---|
| *Material A bzw. B* | $\mu$V/K | W/(m*K) |
| Konstantan (Cu, Ni, Mn, Fe) | -35.1 | 20 |
| Alumel (Ni, Mn, Al, Si) | -17.3 | 30 |
| Nickel (Ni) | -15 | 90 |
| Kupfer (Cu) | 6 | 400 |
| Kohlenstoffstahl | 6.5 | 45 |
| Molybdän (Mo) | 10 | 138 |
| Eisen (Fe) | 19.8 | 80 |
| Chromel (Ni-Cr) | 24 | 11.3 |
| Antimon (Sb) | 47 | 20 |

Die Absolutwerte oder Beträge der Seebeck-Koeffizienten der Materialien A, B sollten nicht um mehr als 50 % voneinander abweichen. Damit fallen einige Materialkombinationen für die Materialien A, B heraus.

Eine derartige Rechnung ergibt beispielsweise für die Kombination von Nickel und Eisen,

$$|SeebeckFe| - |SeebeckNi| / |SeebeckFe|,$$

eine Seebeck-Koeffizientabweichung von etwa 24%.

Wenn die Materialien A, B und damit die Thermosäulen 1, 2 zu stark unterschiedliche thermische Leitfähigkeiten bzw. Wärmeleitfähigkeiten respektive Wärmewiderstände aufweisen, kommt es zu starken mechanischen Spannungen, welche in der Regel anisotrop sind, sodass das fertige Peltierelement P ungewünscht und unvorhersagbar mechanisch verspannt ist oder bei der Laserbestrahlung verspannt wird.

Besonders bevorzugt ist eine Kombination zweier Materialien A, B deren Wärmeleitfähigkeiten um maximal 50%, bevorzugt weniger als 25% voneinander abweichen.

Dabei weisen Nickel und Eisen als Material A und B, die optimale Wärmeleitfähigkeitsabweichung von |WärmeleitfähigkeitNi|-|WärmeleitfähigkeitFe|/ |WärmeleitfähigkeitNi| ~11% bei gleichzeitig hoher thermischer Leitfähigkeit auf.

Die besten Ergebnisse wurden mit Materialien A, B mit Wärmeleitfähigkeiten grössergleich 5 W/(m*K) erreicht.

**Verwendung**

Ein derart gestaltetes Peltierelement P wird als Hochleistungsstrahlungssensor, insbesondere für hochenergetische Laserstrahlung mit Strahlungsleistungen S grösser 100Watt verwendet. Die zu untersuchende bzw. zu messende Laserstrahlung L fällt auf die laserseitige Isolatorlage 5. Dabei wird durch die Laserstrahlung ein Wärmefluss in Querrichtung Q des Peltierelementes P ausgelöst. Dieser Wärmefluss kann durch die Messung einer elektrischen Spannung V zwischen den Säulenbrücken 4' gemessen werden, wodurch die Hochleistungsstrahlung charakterisiert werden kann.

Optional ist auf der Oberseite des Peltierelementes P, genauer auf der der späteren Laserstrahlung L zugewandten Seite der laserseitigen Isolatorlage 5, eine optische Absorberlage A angeordnet. Diese Absorberlage A absorbiert die auftreffende Laserstrahlung L und leitet diese zur benachbarten Isolatorlage 5. Als Absorberlage A kann eine Farbstoffschicht mit ausreichender Dicke eingesetzt werden, deren Absorptionsmaximum bei der genutzten Laserwellenlänge liegt. Auch ein Halbleiter-Bauelement oder eine Lage aus Aluminium können die Absorberlage A bilden. Die Absorberlage A ist auf die Oberfläche der laserseitigen Isolatorlage 5 flächig aufgesprüht, -gedruckt, -geklebt, - geschweisst, gedampft, gesputtertoder sogar aufgelötet.

Auf der Unterseite des Peltierelementes P, bzw. der von der Bestrahlung abgewandten Oberfläche der unteren Isolatorlage 5' kann ein mittels thermisch leitfähiger Montagemateriallage M befestigter Kühlkörper K angeordnet sein. Der Kühlkörper K ist praktisch unterhalb des Peltierelementes P angeordnet und nimmt durch in Querrichtung Q durchfliessende Wärmemengen auf. Entsprechend muss der Kühlkörper K aus einem geeigneten Material bestehen, welches die Wärme vom Peltierelement P wegleiten kann.

Da die Materialien A, B der Thermosäulen 1, 2 metallisch sind, ergibt sich eine entsprechende Duktilität dieser Metalle. Die Materialien A, B sollen lötbar sein, um die Herstellung zu vereinfachen.

Einige bauliche Massnahmen der Peltierelemente P haben sich als besonders vorteilhaft erwiesen. So sind die Zwischenräume bzw. Abstände zwischen benachbarten Thermosäulen 1, 2 mit höchstens 20% der Breite in einer Längsrichtung L bzw. Tiefe, in einer Richtung senkrecht zur Darstellungsebene der Thermosäulen 1, 2 des Peltierelementes P gewählt worden; Aus Fertigungsgründen betragen dieselben Zwischenräume bzw. Abstände bevorzugterweise mindestens 0.25 mm.

Die Höhen der Thermosäulen 1, 2 in Richtung Querachse Q sollten zwischen 1mm und 5mm liegen, bevorzugt bei 2mm und die Breiten in Richtung Längsachse Z sollen grösser als die Höhen sein, bevorzugt 3 mm.

Für die Säulenbrücken 4, 4' wird bevorzugt Kupfer oder eine Kupferlegierung verwendet.

Die Messelektronik, mit welcher die einfallende Strahlungsleistung S auf das Peltierelement P bzw. die elektrische Spannung gemessen wird, ist nicht im Detail dargestellt, da hier die Gestaltung des Petierelementes P entscheidend ist. Dem Fachmann sind mögliche Ausgestaltungen einer geeigneten Messelektronik bekannt.

**Bezugszeichenliste**

P Peltierelement

1 Thermosäule Typ A mit Material A (thermisch leitfähig, hohe thermische Leitfähigkeit, halbleiterfrei, duktil, bevorzugt Ni oder Fe )

2 Thermosäule Typ B mit Material B (thermisch leitfähig, hohe thermische Leitfähigkeit, halbleiterfrei, duktil, bevorzugt Ni oder Fe )

3 Säulenlotschichtlage (thermisch leitfähig, Weich- oder Hartlot auf Basis von Zinn, Silber, Messing, Kupfer)

4, 4' Säulenbrücken (Metall, bevorzugt Cu, thermisch und el. Hochleitend und lötbar)

5, 5' Isolatorlage (hitzebeständig, thermisch leitend, el. Isolator, bevorzugt Aluminiumoxid, Aluminiumnitrid, Berylliumoxid)

A Optische Absorberlage

M Montagemateriallage (thermisch leitfähig)

K Kühlkörper

Q Querrichtung

Z Längsachse

L Strahlung /Laserstrahlung

S Strahlungsleistung

**Patentansprüche**

1. Verwendung eines Peltierelements (P) als

Hochleistungsstrahlungssensor für elektromagnetische Strahlung mit Wellenlängen bis zu 100$\mu$m mit Strahlungsleistungen grösser 100 Watt, wobei eine elektrische Spannung am Peltierelement (P) je nach durch die Laserstrahlung induziertem Wärmefluss in Querrichtung des Peltierelementes (P), senkrecht zur Längsausdehnung des Peltierelementes (P) gemessen wird, wobei

das Peltierelement (P) Isolatorlagen (5, 5'), Säulenbrücken (4, 4'), Säulenlotschichtlagen (3) und eine thermisch aktive Lage aus alternierend angeordneten ersten Thermosäulen (1) umfassend ein erstes Material (A) und zweiten Thermosäulen (2) umfassend ein zweites Material (B) aufweist und die Thermosäulen (1, 2) halbleiterfrei ausgeführt sind,

wobei das erste und zweite Material (A, B) ein Metall bzw. eine Metalllegierung ist und das erste Material (A) einen Seebeck-Koeffizient, gemessen relativ zu Platin bei 273 K grösser 6 $\mu$V/K und das zweite Material (B) einen Seebeck-Koeffizient, gemessen relativ zu Platin bei 273 K kleinergleich -15 $\mu$V/K aufweist,

die Absolutwerte der Seebeck-Koeffizienten der ersten und zweiten Materialien (A, B), gemessen relativ zu Platin bei 273 K des ersten und zweiten Materials (A, B) um weniger als 50 % voneinander abweichen

und die Wärmeleitfähigkeiten des ersten und zweiten Materials (A, B) um maximal 50% voneinander abweichen und wobei der thermische Gesamtwiderstand des Peltierelements (P) über das gesamte Peltierelements (P) in Querrichtung (Q) gemessen 2 K/W nicht überschreitet.

2. Verwendung eines Peltierelements (P) als Hochleistungsstrahlungssensor nach Anspruch 1, wobei die die Wärmeleitfähigkeiten des ersten und zweiten Materials (A, B) weniger als 25% voneinander abweichen und der thermische Gesamtwiderstand des Peltierelements (P) über das gesamte Peltierelements (P) in Querrichtung (Q) gemessen 0.2 K/W nicht überschreitet.

3. Verwendung eines Peltierelements (P) als Hochleistungsstrahlungssensor nach einem der vorhergehenden Ansprüche, wobei ein erstes und zweites Material (A, B) gewählt wird, deren Wärmeleitfähigkeit grössergleich 5 W/(m*K) sind.

4. Verwendung eines Peltierelements (P) als Hochleistungsstrahlungssensor nach einem der vorhergehenden Ansprüche, wobei Eisen bzw. eine Eisenlegierung als erstes Material (A) und Nickel bzw. eine Nickellegierung als zweites Material (B) für die Thermosäulen (1, 2) verwendet werden.

5. Verwendung eines Peltierelements (P) als Hochleistungsstrahlungssensor nach einem der vorhergehenden Ansprüche, wobei Kupfer bzw. eine Kupferlegierung als Material der Säulenbrücken (4, 4') gewählt ist.

6. Verwendung eines Peltierelements (P) als Hochleistungsstrahlungssensor nach einem der vorhergehenden Ansprüche, wobei auf der bestrahlungsseitigen Isolatorlage (5) eine Absorberlage (A) in Form einer Farbstoffschicht, eines Halbleiter-Bauelements und/oder einer Aluminium-/Aluminiumlegierungslage vollflächig überspannend aufgebracht ist.

7. Verwendung eines Peltierelements (P) als Hochleistungsstrahlungssensor nach Anspruch 6, wobei die Absorberlage (A) auf die Oberfläche der strahlungsseiigen Isolatorlage (5) flächig aufgesprüht, -gedruckt, -geklebt, - geschweisst, bedampft, gesputtert oder aufgelötet ist.

8. Hochleistungsstrahlungssensor für hochenergetische

Laserstrahlung mit Wellenlängen bis zu 100 $\mu$m mit Strahlungsleistungen grösser 100 Watt,

wobei der Hochleistungsstrahlungssensor ein Peltierelment (P) mit Isolatorlagen (5, 5'), Säulenbrücken (4, 4'), Säulenlotschichtlagen (3) und eine thermisch aktive Lage aus alternierend angeordneten ersten Thermosäulen (1) umfassend ein erstes Material (A) und zweiten Thermosäulen (2) umfassend ein zweites Material (B) aufweist, wobei die Thermosäulen (1, 2) halbleiterfrei ausgeführt sind,

wobei das erste und zweite Material (A, B) ein Metall bzw. eine Metalllegierung ist und das erste Material (A) einen Seebeck-Koeffizient, gemessen relativ zu Platin bei 273 K grösser 6 $\mu$V/K und das zweite Material (B) einen Seebeck-Koeffizient, gemessen relativ zu Platin bei 273 K kleinergleich -15 $\mu$V/K aufweist, die Absolutwerte der Seebeck-Koeffizienten der ersten und zweiten Materialien (A, B), gemessen relativ zu Platin bei 273 K des ersten und zweiten Materials (A, B) um weniger als 50 % voneinander abweichen und die Wärmeleitfähigkeiten des ersten und zweiten Materials (A, B) um maximal 50% voneinander abweichen und der thermische Gesamtwiderstand des Peltierelements (P) über das gesamte Peltierelements (P) in Querrichtung (Q) gemessen 2 K/W nicht überschreitet.

9. Hochleistungsstrahlungssensor nach Anspruch 7, wobei die Wärmeleitfähigkeiten des ersten und zweiten Materials (A, B) um weniger als 25% voneinander abweichen.

10. Hochleistungsstrahlungssensor nach Anspruch 9, wobei das erste und das zweite Material (A, B) eine Wärmeleitfähigkeit grössergleich 5 W/(m*K) aufweist.

11. Hochleistungsstrahlungssensor nach einem der Ansprüche 9 bis 11, wobei Eisen bzw. eine Eisenlegierung als erstes Material (A) und Nickel bzw. eine Nickellegierung als zweites Material (B) für die Thermosäulen (1, 2) gewählt ist.

12. Hochleistungsstrahlungssensor nach einem der Ansprüche 9 bis 12, wobei Kupfer bzw. eine Kupferlegierung als Material der Säulenbrücken (4, 4') gewählt ist.

13. Hochleistungsstrahlungssensor nach einem der Ansprüche 7 bis 11, wobei auf der laserseitigen Isolatorlage (5) eine Absorberlage (A) in Form einer Farbstoffschicht, eines Halbleiter-Bauelements oder einer Aluminiumlage vollflächig überspannend aufgebracht ist.

14. Hochleistungsstrahlungssensor nach Anspruch 12, wobei die Absorberlage (A) auf die Oberfläche der laserseitigen Isolatorlage (5) flächig aufgesprüht, -gedruckt, -geklebt, - geschweisst oder aufgelötet ist.

**Claims**

1. Use of a Peltier element (P) as a high-performance radiation sensor for electromagnetic radiation with wavelengths up to 100um with radiant power outputs greater than 100 watts, wherein an electrical voltage is measured at the Peltier element (P) according to the radiation-induced heat flow in the transverse direction of the Peltier element (P), perpendicular to the longitudinal extension of the Peltier element (P), wherein

   the Peltier element (P) has insulator layers (5, 5'), column bridges (4, 4'), column solder layers (3) and a thermally active layer consisting of alternately arranged first thermopiles (1) comprising a first material (A) and second thermopiles (2) comprising a second material (B) and the thermopiles (1, 2) are formed without semiconductors, wherein the first and second material (A, B) is a metal or a metal alloy, and the first material (A) has a Seebeck coefficient, measured relative to platinum at 273 K, of greater than 6 $\mu$V/K, and the second material (B) has a Seebeck coefficient, measured relative to platinum at 273 K, of less than or equal to -15 $\mu$V/K, the absolute values of the Seebeck coefficients of the first and second materials (A, B), measured relative to platinum at 273 K, differ from each other by less than 50 % and the thermal conductivities of the first and second material (A, B) differ from each other by a maximum of 50 % and wherein the total thermal resistance of the Peltier element (P) over the entire Peltier element (P) measured in the transverse direction (Q) does not exceed 2 K/W.

2. Use of a Peltier element (P) as a high-performance radiation sensor according to Claim 1, wherein the thermal conductivities of the first and second material (A, B) deviate from each other by less than 25 % and the total thermal resistance of the Peltier element (P) over the entire Peltier element (P) measured in the transverse direction (Q) does not exceed 0.2 K/W.

3. Use of a Peltier element (P) as a high-performance radiation sensor according to any one of the preceding claims, wherein a first and second material (A, B) is selected, the thermal conductivity of which is greater than or equal to 5 W/(m*K).

4. Use of a Peltier element (P) as a high-performance radiation sensor according to any one of the preceding claims, wherein iron or an iron alloy is used as the first material (A) and nickel or a nickel alloy is used as the second material (B) for the thermopiles (1, 2).

5. Use of a Peltier element (P) as a high-performance radiation sensor according to any one of the preceding claims, wherein copper or a copper alloy is selected as the material of the column bridges (4, 4').

6. Use of a Peltier element (P) as a high-performance radiation sensor according to any one of the preceding claims, wherein an absorber layer (A) in the form of a dye layer, a semiconductor component and/or an aluminium/aluminium alloy layer is applied over the entire surface of the irradiation-side insulator layer (5) .

7. Use of a Peltier element (P) as a high-performance radiation sensor according to Claim 6, wherein the absorber layer (A) is sprayed, printed, glued, welded, evaporated, sputtered or soldered onto the surface of the irradiation-side insulator layer (5).

8. High-performance radiation sensor for high-energy laser radiation with wavelengths up to 100 um with radiation power outputs greater than 100 watts, wherein the high-performance radiation sensor has a Peltier element (P) with insulator layers (5, 5'), column bridges (4, 4'), column solder layers (3) and a thermally active layer consisting of alternately arranged first thermopiles (1) comprising a first material (A) and second thermopiles (2) comprising a second material (B), wherein the thermopiles (1, 2) are formed without semiconductors,

wherein the first and second material (A, B) is a metal or a metal alloy and the first material (A) has a Seebeck coefficient, measured relative to platinum at 273 K, of greater than 6 $\mu$V/K, and the second material (B) has a Seebeck coefficient, measured relative to platinum at 273 K, of less than or equal to -15 $\mu$V/K,
the absolute values of the Seebeck coefficients of the first and second materials (A, B), measured relative to platinum at 273 K, differ from each other by less than 50 % and the thermal conductivities of the first and second material (A, B) differ from each other by a maximum of 50 %; and
the total thermal resistance of the Peltier element (P) over the entire Peltier element (P) measured in the transverse direction (Q) does not exceed 2 K/W.

9. High-performance radiation sensor according to Claim 7, wherein the thermal conductivities of the first and second material (A, B) differ from each other by less than 25 %.

10. High-performance radiation sensor according to Claim 9, wherein the first and second material (A, B) have a thermal conductivity of greater than or equal to 5 W/(m*K).

11. High-performance radiation sensor according to any one of Claims 9 to 11, wherein iron or an iron alloy is selected as the first material (A) and nickel or a nickel alloy is selected as the second material (B) for the thermopiles (1, 2).

12. High-performance radiation sensor according to any one of Claims 9 to 12, wherein copper or a copper alloy is selected as the material of the column bridges (4, 4').

13. High-performance radiation sensor according to any one of Claims 7 to 11, wherein an absorber layer (A) in the form of a dye layer, a semiconductor component and/or an aluminium layer is applied over the entire surface of the laser-side insulator layer (5).

14. High-performance radiation sensor according to Claim 12, wherein the absorber layer (A) is sprayed, printed, glued, welded or soldered onto the surface of the laser-side insulator layer (5).

**Revendications**

1. Utilisation d'un élément Peltier (P) en tant que capteur de rayonnement à haute puissance pour un rayonnement électromagnétique avec des longueurs d'ondes allant jusqu'à 100 $\mu$m avec des puissances de rayonnement supérieures à 100 Watt, sachant qu'une tension électrique sur l'élément Peltier (P) est mesurée selon le flux thermique induit par le rayonnement laser dans la direction transversale de l'élément Peltier (P), perpendiculairement à l'extension longitudinale de l'élément Peltier (P),
sachant que

l'élément Peltier (P) comporte des couches isolantes (5, 5'), des ponts à colonnes (4, 4'), des supports de couche de brasage de colonne (3) et une couche thermiquement active en premières colonnes thermiques disposées en alternance (1) comprenant un premier matériau (A) et en deuxièmes colonnes thermiques (2) comprenant un deuxième matériau (B), et les colonnes thermiques (1, 2) sont exécutées dépourvues de semiconducteurs,

sachant que le premier et le deuxième matériau (A, B) sont un métal ou un alliage métallique et le premier matériau (A) comporte un coefficient de Seebeck, mesuré par rapport au platine à 273 K supérieur de 6 μV/K et le deuxième matériau (B) un coefficient de Seebeck, mesuré par rapport au platine à 273 K inférieur ou égal à -15 μV/K,

les valeurs absolues des coefficients de Seebeck du premier et du deuxième matériau (A, B), mesurées par rapport au platine à 273 K du premier et du deuxième matériau (A, B) diffèrent de moins de 50 % les unes des autres,

et les conductivités thermiques du premier et deuxième matériau (A, B) diffèrent au maximum de 50 % les unes des autres,

et sachant que la résistance thermique totale de l'élément Peltier (P) ne dépasse pas 2 K/W mesurée sur tout l'élément Peltier (P) en direction transversale (Q).

2. Utilisation d'un élément Peltier (P) en tant que capteur de rayonnement à haute puissance selon la revendication 1, sachant que les conductivités thermiques du premier et du deuxième matériau (A, B) diffèrent de moins de 25 % l'une de l'autre et la résistance thermique totale de l'élément Peltier (P) mesurée sur tout l'élément Peltier (P) en direction transversale (Q) ne dépasse pas 0,2 K/W.

3. Utilisation d'un élément Peltier (P) en tant que capteur de rayonnement à haute puissance selon l'une quelconque des revendications précédentes, sachant qu'un premier et un deuxième matériau (A, B) sont choisis, dont la conductivité thermique est égale ou supérieure à 5 W/(m*K).

4. Utilisation d'un élément Peltier (P) en tant que capteur de rayonnement à haute puissance selon l'une quelconque des revendications précédentes, sachant que du fer ou un alliage de fer est choisi comme premier matériau (A) et du nickel ou un alliage de nickel comme deuxième matériau (B) pour les colonnes thermiques (1, 2).

5. Utilisation d'un élément Peltier (P) en tant que capteur de rayonnement à haute puissance selon l'une quelconque des revendications précédentes, sachant que du cuivre ou un alliage de cuivre est choisi comme matériau des ponts de colonnes (4, 4').

6. Utilisation d'un élément Peltier (P) en tant que capteur de rayonnement à haute puissance selon l'une quelconque des revendications précédentes, sachant qu'une couche absorbante (A) sous la forme d'une couche de colorant, d'un composant à semiconducteurs et/ou d'un support d'aluminium/d'alliage d'aluminium est appliquée recouvrant toute la surface sur la couche isolante (5) du côté rayonnement.

7. Utilisation d'un élément Peltier (P) en tant que capteur de rayonnement à haute puissance selon la revendication 6, sachant que la couche absorbante (A) est aspergée, comprimée, collée, soudée, vaporisée, pulvérisée ou brasée sur la surface de la couche isolante (5) côté rayonnement.

8. Capteur de rayonnement à haute puissance pour rayonnement laser à haute énergie avec des longueurs d'ondes jusqu'à 100 μm avec des puissances de rayonnement supérieures à 100 Watt,

sachant que le capteur de rayonnement à haute puissance comporte un élément Peltier (P) avec des couches isolantes (5, 5'), des ponts à colonnes (4, 4'), des supports de couche de brasage de colonne (3) et une couche thermiquement active en premières colonnes thermiques disposées en alternance (1) comprenant un premier matériau (A) et des deuxièmes colonnes thermiques (2) comprenant un deuxième matériau (B), sachant que les colonnes thermiques (1, 2) sont exécutées dépourvues de semiconducteurs,

sachant que le premier et le deuxième matériau (A, B) estt un métal ou un alliage métallique et le premier matériau (A) comporte un coefficient de Seebeck, mesuré par rapport au platine à 273 K supérieure de 6 μV/K et le deuxième matériau (B) un coefficient de Seebeck, mesuré par rapport au platine à 273 K inférieur ou égal à -15 μV/K,

les valeurs absolues des coefficients de Seebeck du premier et du deuxième matériau (A, B), mesurées par rapport au platine à 273 K du premier et deuxième matériau (A, B) diffèrent de moins de 50 % les unes des autres et les conductivités thermiques du premier et deuxième matériau (A, B) diffèrent au maximum de 50 % les unes des autres, et
la résistance thermique totale de l'élément Peltier (P) ne dépasse pas 2 K/W mesurée sur tout l'élément Peltier (P) en direction transversale (Q).

9. Capteur de rayonnement à haute puissance selon la revendication 7, sachant que les conductivités thermiques du premier et du deuxième matériau (A, B) diffèrent de moins de 25 % l'une de l'autre.

10. Capteur de rayonnement à haute puissance selon la revendication 9, sachant que le premier et le deuxième matériau (A, B) comportent une conductivité thermique égale ou supérieure à 5 W/(m*K).

11. Capteur de rayonnement à haute puissance selon l'une quelconque des revendications 9 à 11, sachant que le fer ou un alliage de fer est choisi comme premier matériau (A) et le nickel ou un alliage de nickel comme deuxième matériau (B) pour les colonnes thermiques (1, 2) .

12. Capteur de rayonnement à haute puissance selon l'une quelconque des revendications 9 à 12, sachant que le cuivre ou un alliage de cuivre est choisi comme matériau des ponts de colonnes (4, 4').

13. Capteur de rayonnement à haute puissance selon l'une quelconque des revendications 7 à 11, sachant que sur la couche isolante (5) côté laser, est appliquée recouvrant toute la surface une couche absorbante (A) sous la forme d'une couche de colorant, d'un composant à semiconducteurs ou d'une couche d'aluminium.

14. Capteur de rayonnement à haute puissance selon la revendication 12, sachant que la couche absorbante (A) est aspergée, comprimée, collée, soudée ou brasée en surface sur la surface de la couche isolante (5) côté laser.

# FIG. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19804487
- US 4641134 A
- DE 10339952
- US 3226804 A